# EUROPEAN PATENT SPECIFICATION

(11) **EP 1 514 234 B1**
(45) Date of publication and mention of the grant of the patent: **25.10.2006**
(21) Application number: 03735897.5
(22) Date of filing: 17.06.2003
(51) Int. Cl.: G06K 19/077

(54) **TAPE MANUFACTURING**
HERSTELLUNGSVERFAHREN EINES BANDES
FABRICATION DE BANDES

(30) Priority: 19.06.2002 EP 02291536
(43) Date of publication of application: 16.03.2005
(73) Proprietor: Axalto SA, 92120 Montrouge (FR)
(72) Inventor: AUDOUX, Jean-Noel, F-45100 Orléans (FR); LIGNEAU, Guillaume, F-45650 Saint-Jean le Blanc (FR); REIGNOUX, Yves, F-45370 Clery Saint-André (FR)
(74) Representative: Cour, Pierre
(86) International application number: PCT/IB2003/002654
(87) International publication number: WO 2004/001663

(56) References cited:
- EP-A- 0 913 268
- EP-A- 1 130 542
- US-A- 4 897 534

## Description

### FIELD OF THE INVENTION

The invention relates to manufacturing a tape to which a plurality of elements is affixed. The invention may be applied in, for example, the manufacturing of smart cards.

### BACKGROUND OF THE INVENTION

EP 1 130 542 A describes a method of manufacturing smart cards which involves a tape with electrical contacts to which a plurality of chips is affixed. Such a tape is often referred to as a "leadframe".

In a gluing step, the chips are glued to the tape by means of a glue in a liquid state, so as to obtain a glued tape.

In a heating step, the glued tape goes through an in-line oven, so that the glue reaches a solid state.

The tape thus obtained is cut so as to obtain electrical modules.

### SUMMARY OF THE INVENTION

An object of the invention is to reduce the costs.

According to one aspect of the invention, a method of manufacturing a tape (T) to which a plurality of semiconductor devices (C) are affixed by means of a glue in a solid state, the method comprising a gluing step, in which elements (C) are glued to a basic tape (T) by means of a glue in a liquid state so as to obtain a glued tape, the method being characterised in that the gluing step is followed by:
- a winding step, in which the glued tape (T) is wound while the glue is in a state between the liquid state and the solid state, so as to obtain a winded glued tape; and
- a heating step, in which the winded glued tape is heated, so that the glue reaches the solid state.

The method according to the invention does not require an in-line oven. To the contrary, with the method of the invention it is possible to replace the in-line oven, which is big and costly, by a much smaller oven, for example, a static oven or a stream oven. Consequently, the invention allows a reducing of the costs.

### BRIEF DESCRIPTION OF THE DRAWINGS

- Fig. 1: illustrates a tape;
- Fig. 2: illustrates a glue depositing step and a chip depositing step;
- Fig. 3: illustrates a first winding step;
- Fig. 4: illustrates a first heating step;
- Fig. 5: illustrates a connecting step;
- Fig. 6: illustrates a resin depositing step;
- Fig. 7: illustrates a second winding step;
- Fig. 8: illustrates a second heating step;
- Fig. 9: illustrates a cutting step and an embedding step; and
- Fig. 10: is a cross section drawing, which illustrates a reel.

### DETAILED DESCRIPTION

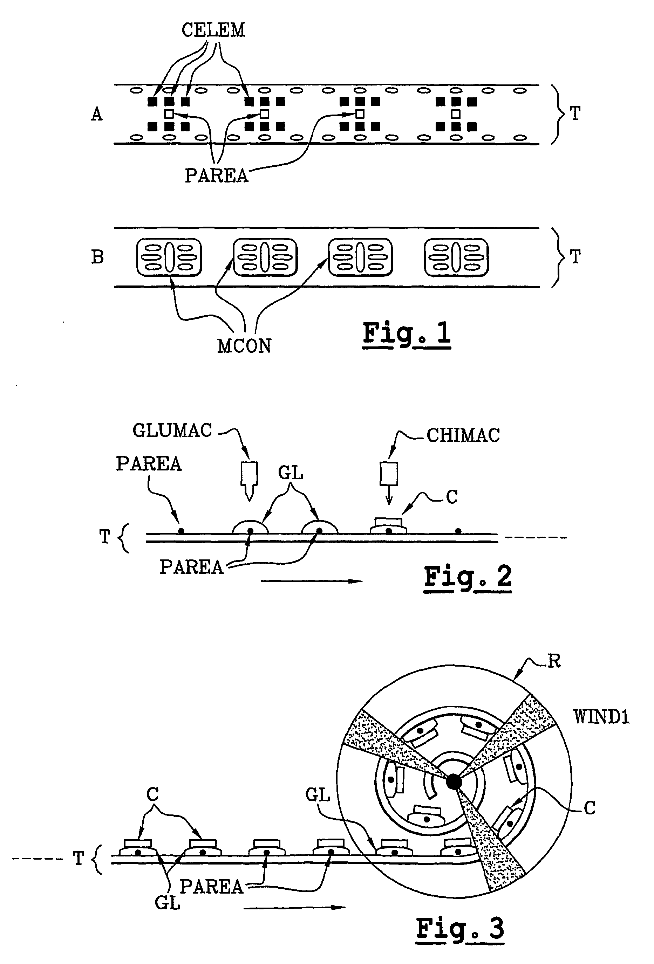

Figure 1 illustrates the structure of a basic tape T. The basic tape T comprises a first side A and a second side B. The first side A comprises a plurality of conducting elements CELEM and a plurality of predefined areas PAREA. The side B comprises metallic contacts MCON. The conducting element CELEM are electrically connected to the metallic contacts MCON. The basic tape T may comprise, for example, epoxy resin impregnated with glass fiber.

Figure 2 illustrates a glue depositing step, in which a glue depositing machine GLUMAC deposits glue GL in a substantially liquid state on a predefined area PAREA. The glue GL can be a thermo-hardening glue, for example, a hot melt glue or an epoxy-based glue. When heated, a thermo-hardening glue is a glue which polymerizes in a non-reversible manner. The glue thus becomes substantially solid. Figure 2 further illustrates a chip depositing step, in which a chip depositing machine CHIMAC deposits a chip C on a glued predefined area PAREA.

Figure 3 illustrates a first tape winding step WIND 1, which follows the chip depositing step CHIPDEP. In the first winding step WIND 1, the basic tape T comprising the glued chips C is wound in a reel R. The glue is between the liquid state and the solid state. That is, the glue is not yet fully hardened. Preferably, the viscosity of the glue is sufficiently high so that the glue does not spread out too much and so that the chips remain affixed to the tape. In practice, the viscosity required depends on the surface tension of the tape and the surface tension of the chips. The higher the surface tension is, the higher the viscosity needs to be.

In the glue depositing step GLUDEP the glue GL can have, for example, a viscosity of 8000 mPa/s at a temperature of 25°C for chips having an average surface tension of roughly about 30 mN/m.

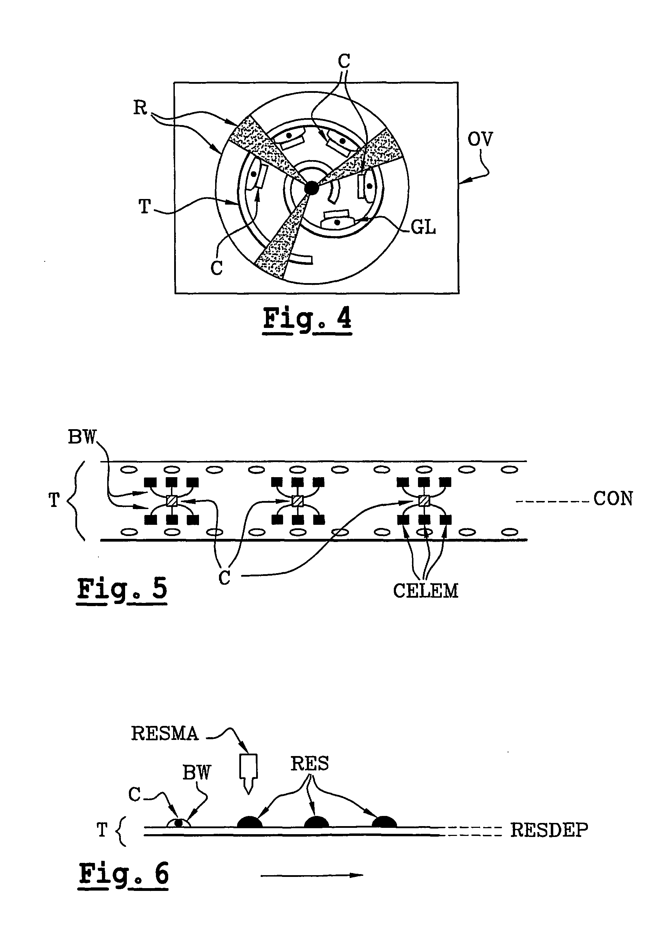

Figure 4 illustrates a first heating step, which follows the first tape winding step WIND1. In the first heating step, the reel R comprising the basic tape T is placed in an oven OV. The temperature may be comprised, for example, between 120°C and 150°C. The basic tape T can be heated, for example, between 60 minutes and 90 minutes. Advantageously the oven OV is just big enough to contain the reel R. The oven OV can be, for example, a static oven or a stream oven. No in-line oven is needed thus saving place and money. After the first heating step, the glue GL has reached its definitive, solid state so that the chips C are affixed to the basic tape T.

Figure 5 illustrates a connecting step CON, in which the chips C are connected to the connecting elements CELEM with, for example, bonding wires BW.

Figure 6 further illustrates a resin depositing step RESDEP, in which a resin depositing machine RESMAC deposits resin RES in a substantially liquid state on the connected chips C to protect them. The resin belongs, for example, to the epoxyde chemical family. The resin can be, for example, a thermo hardening resin. Advantageously, a thin cover sheet is deposited on the resin so as to limit the spreading of the resin.

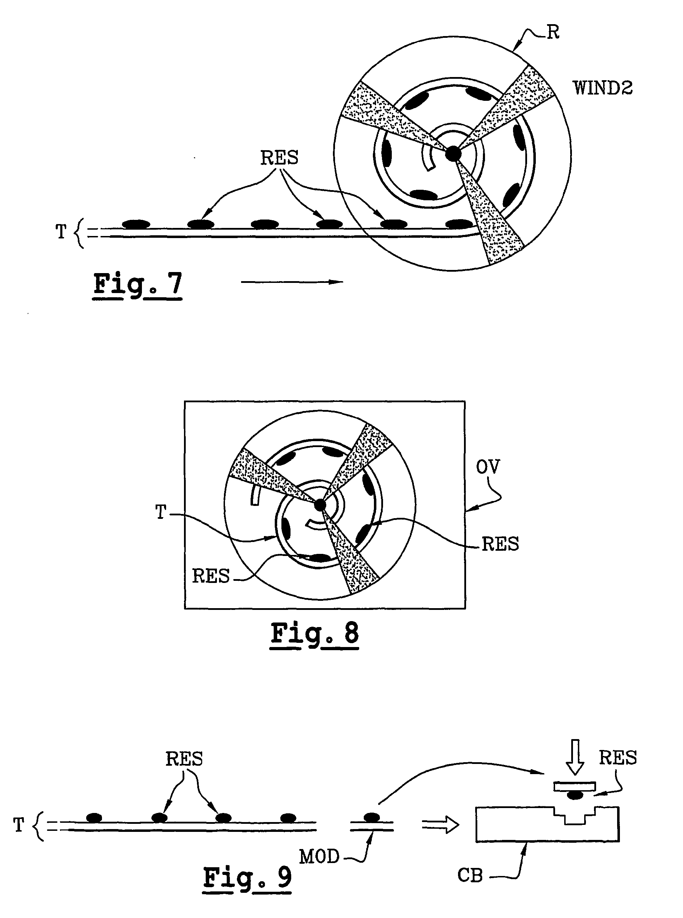

Figure 7 illustrates a second winding step WIND2, in which the basic tape T comprising the connected chips C is wound in a reel R. The resin is between the liquid state and the solid state. That is, the resin is not yet fully hardened. Preferably, the viscosity of the resin is sufficiently high so that the resin does not spread out too much. In practice, the viscosity required depends on the surface tension of the chips. The higher the surface tension is, the higher the viscosity needs to be.

In the resin depositing step RESDEP, the resin can have, for example, a viscosity of 60 000 mPa/s at a temperature of 25°C for chips having an average surface tension of roughly about 30 mN/m. If a thin cover sheet is used, the resin can have for example, a viscosity of 15 000 mPa/s at a temperature of 25°C for chips having an average surface tension of roughly about 30 mN/m.

Figure 8 illustrates a second heating step, which follows the second winding step WIND2. In the second heating step, the reel R comprising the tape T is placed in an oven OV. The temperature may be comprised, for example, between 120°C and 150°C. The tape T can be heated, for example, between 60 minutes and 90 minutes. After the second heating step, the resin RES has reached its definitive, solid state and the chips are thus protected.

Fig. 9 illustrates a cutting step, which follows the second heating step. In the cutting step, a module MOD is cut from the tape T. A module MOD comprises a glued connected chip protected by the resin RES.

Fig. 9 further illustrates an embedding step, in which the module MOD is embedded in a card body CB.

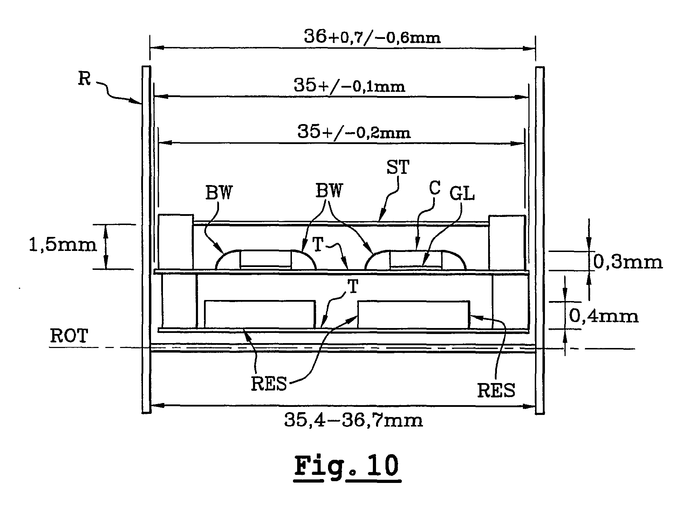

Fig. 10 is a cross section view illustrating a reel R, which can be used in the invention. The reel R comprises a rotation axis ROT. The reel R comprises a spacer tape ST so that the basic tape T is better protected during the first winding step WIND1, the second winding step WIND2 or when, for example, a user carries the reel R. Fig. 10 further illustrates a chip C, which is glued on the basic tape T with glue GL. The chip C comprises bonding wires BW. Fig. 10 also illustrates a chip which is protected with the resin RES. The reel can be made of any material, which can resist to the temperatures of the oven. The material can be, for example, a composite material. The composite material can be, for example, any fibrous material that molds easily with fiberglass or carbon fiber. Advantageously the composite material can be made of fiberglass impregnated, for example, with epoxy resin, in particular an epoxide. The use of composite material, and particularly the use of a fiberglass impregnated with epoxy resin, allows to both design a reel having a big diameter, for example, bigger than 600 mm, in particular 700 mm ; and to keep at the same time reduced plays as illustrated in figure 10.

The description hereinbefore illustrates the following features:
A tape (T) to which a plurality of semiconductor devices (C) are affixed by means of a glue in a solid state is manufactured in the following manner. In a gluing step, in which elements (C) are glued to a basic tape (T) by means of a glue in a liquid state so as to obtain a glued tape. The gluing step is followed by a winding step and a heating step. In the winding step, the glued tape (T) is wound while the glue is in a state between the liquid state and the solid state; so as to obtain a winded glued tape. In the heating step, in the winded glued tape is heated, so that the glue reaches the solid state.

There are various manners to implement the invention.

In the above description the chips C are connected to connecting elements CELEM with bonding wires BW. We can also imagine that the chips are connected using other techniques, for example, a flip chip technique.

Any type of glue or resin having a viscosity that limits the spreading in a winding step can be used.

The invention has been described in the context of the manufacturing of a smartcard. But the invention applies more generally to any method, which involves a tape (T) to which a plurality of elements (C) are affixed. It can be a tape comprising, for example, stamps, flash memory, ducks or any other elements to be affixed on the tape.

## Claims

1. A method of manufacturing a tape (T) to which a plurality of semiconductor devices (C) are affixed by means of a glue in a solid state, the method comprising a gluing step, in which elements (C) are glued to a basic tape (T) by means of a glue in a liquid state so as to obtain a glued tape, the method being **characterised in that** the gluing step is followed by:
- a winding step, in which the glued tape (T) is wound while the glue is in a state between the liquid state and the solid state, so as to obtain a winded glued tape; and
- a heating step, in which the winded glued tape is heated, so that the glue reaches the solid state.

2. The method according to claim 1, **characterized in that** in the winding step, the glued tape (T) is wound on reel (R) made of composite material.

3. The method according to claim 2, **characterized in that** the reel (R) has a diameter bigger than 600 mm.

4. The method according to claim 3, **characterized in that** the reel (R) is made of fiberglass impregnated with epoxy resin.

5. A method of manufacturing a smart card, **characterized in that** the method comprises the following steps:
- a gluing step, in which semiconductor devices (C) are glued to a basic tape (T) by means of a glue in a liquid state so as to obtain a glued tape;
- a winding step, in which the glued tape (T) is wound while the glue is in a state between the liquid state and the solid state, so as to obtain a winded glued tape;
- a heating step, in which the winded glued tape is heated, so that the glue reaches the solid state ;
- a cutting step, in which the tape (T) is cut so as to obtain modules (MOD); and
- an embedding step, in which a module (MOD) is embedded in a cardbody (CB) so as to obtain a smart card.

## Patentansprüche

1. Ein Verfahren zur Herstellung eines Bandes (T), an dem eine Vielzahl von Halbleiterbauteilen (C) mittels Klebestoff im Festzustand befestigt sind, das Verfahren umfasst einen Schritt zum Kleben, in dem die Elemente (C) mittels Klebestoff im Flüssigzustand an ein Grundband (T) festgeklebt werden, so dass ein geklebtes Band hergestellt wird ; das Verfahren ist **dadurch gekennzeichnet, dass** sich an den Klebeschritt Folgendes anschließt :
- ein Wickelschritt, in dem das geklebte Band (T) aufgewickelt wird, während der Klebestoff in einem Zwischenzustand zwischen dem flüssigen und festen Zustand befindlich ist, so dass ein aufgewickeltes geklebtes Band erhalten wird ; und
- ein Heizschritt, in dem das aufgewickelte geklebte Band geheizt wird, so dass der Klebestoff einen Festzustand erreicht.

2. Das Verfahren nach Anspruch 1, **dadurch gekennzeichnet, dass** im Wickelschritt das geklebte Band (T) auf die aus Verbundmaterial bestehende Aufnahmespule (R) aufgewickelt wird.

3. Das Verfahren nach Anspruch 2, **dadurch gekennzeichnet, dass** die Aufnahmespule (R) einen Durchmesser größer als 600 mm aufweist.

4. Das Verfahren nach Anspruch 3, **dadurch gekennzeichnet, dass** die Aufnahmespule (R) aus mit Epoxidharz getränkten Glasfasern besteht.

5. Ein Verfahren zur Herstellung einer Smartkarte, **dadurch gekennzeichnet, dass** das Verfahren die folgenden Schritte aufweist:
- einen Klebeschritt, in dem Halbleiterbauteile (C) mit einem Klebestoff im Flüssigzustand auf das Grundband (T) aufgeklebt werden, so dass ein geklebtes Band entsteht;
- einen Wickelschritt, in dem das geklebte Band (T) aufgewickelt wird, während der Klebestoff in einem Zwischenzustand zwischen dem flüssigen und dem festen Zustand befindlich ist, so dass ein aufgewickeltes geklebtes Band entsteht;
- einen Heizschritt, in dem das aufgewickelte geklebte Band geheizt wird, so dass der Klebestoff einen Festzustand erreicht;
- einen Schneideschritt, in dem das Band (T) geschnitten wird, um Module (MOD) herzustellen; und
- einen Einfügeschritt, in dem ein Modul (MOD) in einen Kartenkörper (CB) eingefügt wird, so dass eine Smartkarte entsteht.

## Revendications

1. Procédé de fabrication d'une bande (T) à laquelle une pluralité de dispositifs à semiconducteurs (C) sont fixés à l'aide d'une colle à l'état solide, le procédé comprenant une étape d'encollage, dans laquelle des éléments (C) sont collés à une bande de base (T) à l'aide d'une colle à l'état liquide de manière à obtenir une bande encollée, le procédé étant **caractérisé en ce que** l'étape d'encollage précède les étapes suivantes :
- une étape d'enroulement, dans laquelle la bande encollée (T) est enroulée alors que la colle se trouve dans un état intermédiaire entre l'état liquide et l'état solide, de manière à obtenir une bande encollée enroulée ; et
- une étape de chauffage, dans laquelle la bande encollée enroulée est chauffée, de manière à solidifier la colle.

2. Procédé selon la revendication 1, **caractérisé en ce que** pendant l'étape d'enroulement, la bande encollée (T) est enroulée sur la bobine (R) constituée d'un matériau composite.

3. Procédé selon la revendication 2, **caractérisé en ce que** la bobine (R) dispose d'un diamètre supérieur à 600 mm.

4. Procédé selon la revendication 3, **caractérisé en ce que** la bobine (R) est constituée de fibre de verre imprégnée de résine époxy.

5. Procédé de fabrication d'une carte à puce, **caractérisé en ce qu'**il comprend les étapes suivantes :
- une étape d'encollage, dans laquelle des dispositifs à semiconducteurs (C) sont collés à la bande de base (T) à l'aide d'une colle à l'état liquide, de manière à obtenir une bande encollée ;
- une étape d'enroulement, dans laquelle la bande encollée (T) est enroulée alors que la colle se trouve dans un état intermédiaire entre l'état liquide et l'état solide, de manière à obtenir une bande encollée enroulée ;
- une étape de chauffage, dans laquelle la bande encollée enroulée est chauffée, de manière à solidifier la colle ;
- une étape de découpe, dans laquelle la bande (T) est découpée afin d'obtenir des modules (MOD) ; et
- une étape d'encartage, dans laquelle un module (MOD) est encarté dans un corps de carte (CB) afin d'obtenir une carte à puce.
